# EUROPEAN PATENT APPLICATION

(11) **EP 1 642 920 A1**
(43) Date of publication of application: **05.04.2006**
(21) Application number: 04746341.9
(22) Date of filing: 24.06.2004
(51) Int. Cl.: C08G 73/08, C09K 11/06, H05B 33/14

(54) **BLUE LIGHT EMITTING POLYMER, METHOD FOR PRODUCING SAME, AND LIGHT EMITTING DEVICE UTILIZING SAME**

(30) Priority: 30.06.2003 JP 2003188390
(71) Applicant: HIROSE ENGINEERING CO., LTD., Tokyo 146-0092 (JP)
(72) Inventor: NAKAYA, Tadao, c/o Hirose Engineering Co., Ltd., Ohta-ku, Tokyo 1460092 (JP); ISHITOBI, Tatsuro c/o Hirose Engineering Co., Ltd., Ohta-ku, Tokyo 1460092 (JP); TOBITA, Michiaki, c/o Hirose Engineering Co., Ltd., Ohta-ku, Tokyo 1460092 (JP); SAIKAWA, Tomoyuki c/o Hirose Engineering Co., Ltd., Ohta-ku, Tokyo 1460092 (JP)
(74) Representative: HOFFMANN EITLE
(86) International application number: PCT/JP2004/008872
(87) International publication number: WO 2005/000942

(57) **Abstract**

The objective of the present invention is to provide a blue light-emitting polymer capable of emitting blue light for a long time, and further excellent in durability, processes of producing the polymer, and a luminescent element. The blue light-emitting polymer of the invention has a repeating unit represented by formula (1): 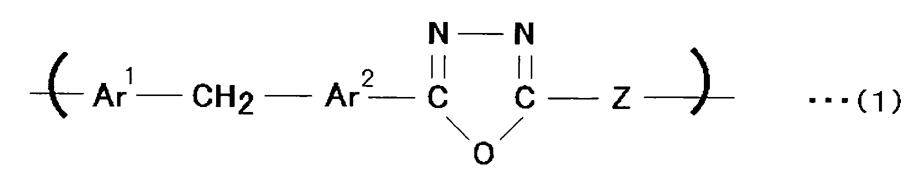 wherein each of Ar¹ and Ar² is a benzene derivative, a naphthalene derivative, or an anthracene derivative. The present invention also provides processes of producing the blue light-emitting polymer, and a luminescent element including the polymer.

## Description

### TECHNICAL FIELD

The present invention relates to a blue light-emitting polymer, processes of preparing the blue light-emitting polymer, and luminescent elements including the blue light-emitting polymer. More specifically, this invention relates to a blue light-emitting polymer capable of emitting blue light at a high luminance for a long time upon the application of electric energy, processes of producing the polymer and luminescent elements including the blue light-emitting polymer.

### BACKGROUND ART

For luminescent compounds that maybe utilized for organic electroluminescent elements, which are often abbreviated to "organic EL elements", have been proposed various low molecular weight organic luminescent compounds.

When a low molecular weight organic luminescent compound is utilized for a luminescent element, the luminescent compound has to be deposited on the light-emitting layer or dispersed in a fixative substance such as polymer. Therefore a process to produce an organic electroluminescent element including a low molecular weight organic luminescent compound requires a step of vapor deposition or a step of high polymer film formation that comprises the application of a high polymer solution including the lowmolecular weight organic luminescent compound. Generally, the step of high polymer film formation is easier than that of vapor deposition.

Another piece of information about the background art is that luminescent polymers, capable of emitting blue light for a long time and excellent in durability, have not been developed.

### DISCLOSURE OF THE INVENTION

### [Problems to be Solved by the Invention]

The objective of the present invention is to provide a blue light-emitting polymer capable of emitting blue light at a high luminance for a long time, and further excellent in durability. This invention also aims for providing processes for producing the blue light-emitting polymer and luminescent elements including the blue light-emitting polymer.

### [Means to Solve the Problems]

The first means to achieve the objective is a blue light-emitting polymer having a repeating unit represented by formula (1): 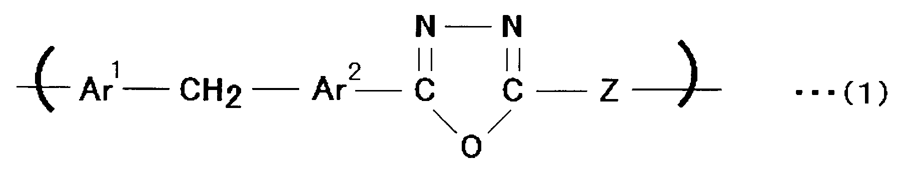 wherein each of Ar¹ and Ar² denotes a group represented by formula (2), (3), (4) or (5), wherein Ar¹ and Ar² may be the same or different from each other; and Z is a single bond or a group represented by formula (6).
Formula (2) is: 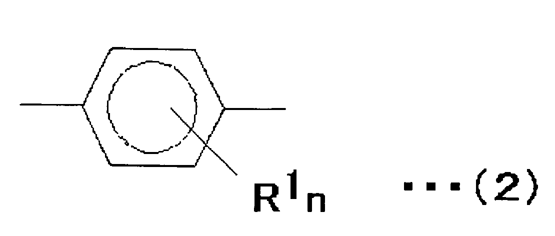 wherein R¹ is a hydrogen atom, an alkyl group having 1 to 10 carbon atoms, an alkoxyl group having 1 to 5 carbon atoms, or an aryl group having 6 to 14 carbon atoms; and "n" denotes an integer from 1 to 4.
Formula (3) is: 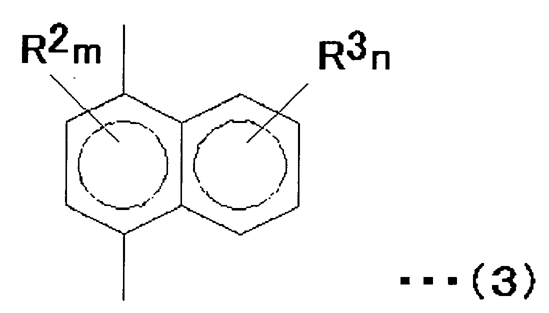 wherein each of R² and R³ denotes a hydrogen atom, an alkyl group having 1 to 10 carbon atoms, an alkoxyl group having 1 to 5 carbon atoms, or an aryl group having 6 to 14 carbon atoms,
wherein R² and R³ may be the same or different from each other; "m" denotes an integer of 1 or 2; and "n" means the same as the above.
Formula (4) is: 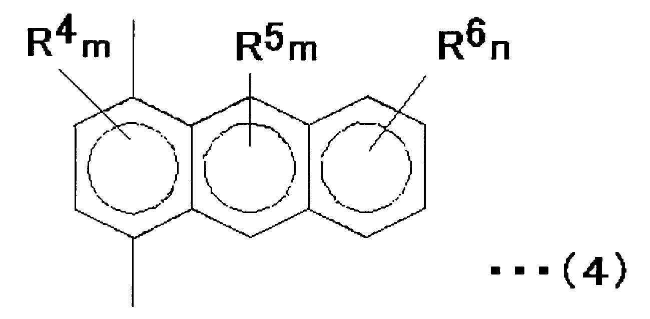 wherein each of R⁴, R⁵ and R⁶ denotes a hydrogen atom, an alkyl group having 1 to 10 carbon atoms, an alkoxyl group having 1 to 5 carbon atoms, or an aryl group having 6 to 14 carbon atoms,
wherein R⁴, R⁵ and R⁶ may be the same or different from one another; "m" and "n" respectively mean the same as the above.
Formula (5) is: 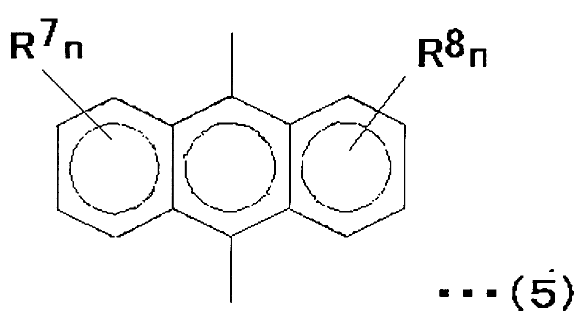 wherein each of R⁷ and R⁸ denotes a hydrogen atom, an alkyl group having 1 to 10 carbon atoms, an alkoxyl group having 1 to 5 carbon atoms, or an aryl group having 6 to 14 carbon atoms,
wherein R⁷ and R⁸ may be the same or different from each other; and "n" means the same as the above.
Formula (6) is: 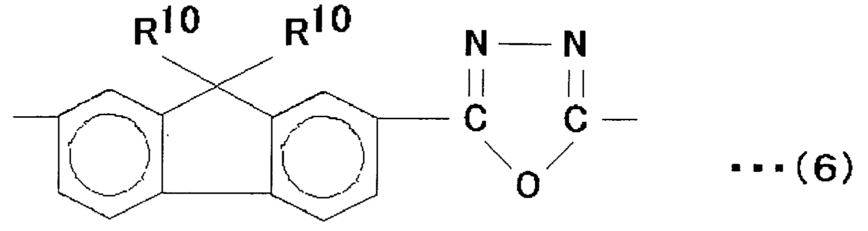 wherein R¹⁰ denotes a hydrogen atom or an alkyl group having 1 to 10 carbon atoms, and two R¹⁰s may be the same or different from each other.

The second means to achieve the objective is a process of producing a blue light-emitting polymer having the repeating unit represented by formula (1), comprising dehydrohalogenating an aromatic compound represented by formula (7) and an aromatic compound with a halogen atom represented by formula (8) to obtain a compound; acetylating the obtained compound; oxidizing the acetylated compound; hydrolyzing the oxidized compound to produce a dicarboxylic acid represented by formula (9); and condensation-polymerizing the dicarboxylic acid (9) and a hydrazinium salt.
Formula (7) is:

**H-Ar**^{**1**}**-H** **(7)**

wherein Ar¹ denotes the same as that defined in relation to the first means.
Formula (8) is:

**H-Ar**^{**2**}**-CH**_{**2**}**X** **(8)**

wherein Ar² denotes the same as that defined in relation to the first means, and X denotes a halogen atom.
Formula (9) is:

**HOOC-Ar**^{**1**}**-CH**_{**2**}**-Ar**^{**2**}**-COOH** **(9)**

The third means to achieve the objective of the present invention is another process of producing a blue light-emitting polymer having the repeating unit represented by formula (1), comprising acetylating a fluorene represented by formula (10); oxidizing the acetylated fluorene; hydrolyzing the oxidized acetylated fluorene to obtain a compound represented by formula (11); and condensation-polymerizing the compound (11) and the compound represented by formula (9) shown hereinbefore in the presence of a hydrazinium salt.
Formula (10) is: 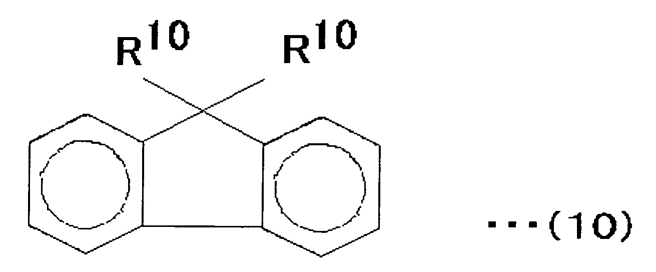 wherein R¹⁰ denotes a hydrogen atom or an alkyl group with 1-10 carbon atoms; and two R¹⁰s may be the same or different from each other.
Formula (11) is:

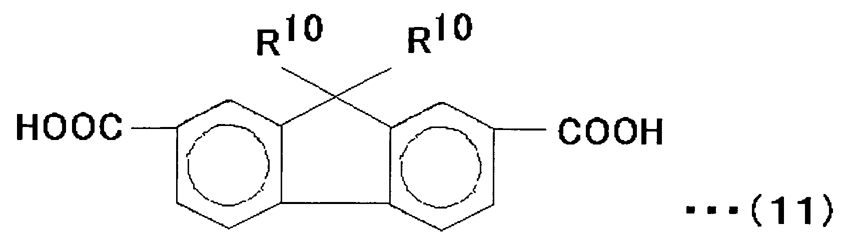

The fourth means is a luminescent element which has a light-emitting layer including a blue light-emitting polymer having the repeating unit represented by formula (1) between a pair of electrodes.

### [Advantages of the Invention]

The present invention can provide a blue light-emitting polymer capable of emitting light at a high luminance for a long time, and furthermore processes of producing the blue light-emitting polymer and a luminescent element including the polymer.

### BRIEF DESCRIPTION OF THE DRAWINGS

Figure 1 is an illustration showing an example of the luminescent element in accordance with the present invention.
Figure 2 is an illustration showing another example of the luminescent element in accordance with the present invention.
Figure 3 is an illustration showing a still another example of the luminescent element in accordance with the present invention.
Figure 4 is an illustration showing a further example of the luminescent element in accordance with the present invention.
Figure 5 is an NMR spectrum chart of the crystals obtained by the dehydrohalogenation in Example 1.
Figure 6 is an IR spectrum chart of the crystals obtained by the dehydrohalogenation in Example 1.
Figure 7 is an NMR spectrum chart of the crystals obtained by the acetylation in Example 1.
Figure 8 is an IR spectrum chart of the crystals obtained by the acetylation in Example 1.
Figure 9 is an NMR spectrum chart of the crystals obtained by the hydrolysis in Example 1.
Figure 10 is an IR spectrum chart of the crystals obtained by the hydrolysis in Example 1.
Figure 11 is an NMR spectrum chart of the film obtained by the condensation-polymerization in Example 1.
Figure 12 is an IR spectrum chart of the film obtained by the condensation-polymerization in Example 1.
Figure 13 is a fluorescence spectrum chart of the polymer obtained in Example 1.
Figure 14 is an IR spectrum chart of the film obtained by the condensation-polymerization in Example 2.
Figure 15 is a fluorescence spectrum chart of the polymer obtained in Example 2.

### [Explanation of Reference Numerals]

### A, B, C ... blue light-emitting element, 1 ... substrate, 2 ... transparent electrode, 3 ... light-emitting layer, 4 ... electrode layer

### BEST MODE TO CARRY OUT THE INVENTION

The blue light-emitting polymer of the present invention has a repeating unit represented by formula (1):

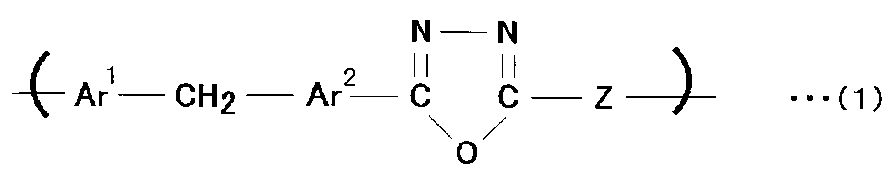

The repeating unit of the blue light-emitting polymer is composed of an oxadiazole ring, a methylene group, a first substituent Ar¹, a second substituent Ar², and a third substituent Z.

The oxadiazole ring has two carbon atoms. One of them is bonded with the second substituent Ar² and the other with the first substituent Ar¹ that belongs to the next repeating unit through the third substituent Z.

The second substituent Ar² is bonded with the oxadiazole ring and with the first substituent Ar¹ through the methylene group. The first substituent Ar¹ is also bonded with a carbon atom of the oxadiazole ring that belongs to the preceding repeating unit through the third substituent Z of the preceding repeating unit. Each of Ar¹ and Ar² denotes one of the following formulas (2) - (5), and Ar¹ and Ar² may be the same or different from each other.

Each of Ar¹ and Ar² may be the group represented by formula (2) below.

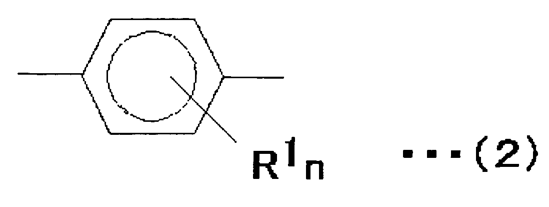

The group represented by formula (2) has a benzene ring as its basic skeleton. One of a pair of p-positioned carbon atoms of the benzene ring is bonded with a carbon atom of the oxadiazole ring, and the other is bonded with the carbon atom of the methylene group. The other carbon atoms of the benzene ring may be bonded with R¹.

R¹ is a hydrogen atom, an alkyl group having 1 to 10 carbon atoms, an alkoxyl group having 1 to 5 carbon atoms, or an aryl group having 6 to 14 carbon atoms.

The alkyl group having 1 to 10 carbon atoms for R¹ includes methyl group, ethyl group, propyl group, isopropyl group, n-butyl group, isobutyl group, sec-butyl group, tert-butyl group, n-pentyl group, sec-pentyl group, tert-pentyl group, a hexyl group, a heptyl group, an octyl group, a nonyl group, a decyl group, etc. Among those are preferred an alkyl group having 1 to 5 carbon atoms, such as methyl group, ethyl group, propyl group, isopropyl group, n-butyl group, isobutyl group, sec-butyl group, tert-butyl group, n-pentyl group, sec-pentyl group, or tert-pentyl group. The most preferable are alkyl groups having 1 to 3 carbon atoms.

The alkyl group having 1 to 10 carbon atoms may be a fluorine atom-including alkyl group where at least one of the hydrogen atoms is replaced with a fluorine atom.

For the fluorine atom-including alkyl group with 1 to 10 carbon atoms is preferred a fluorine atom-including alkyl group with 1 to 3 carbon atoms. Examples of the preferred are fluoromethyl group, difluoromethyl group, trifluoromethyl group, fluoroethyl group, 1,1-difluoroethyl group, 1,2-difluoroethyl group, 1,1,1-trifluoroethyl group, 1,1,2-trifluoroethyl group, 1,2,2-trifluoroethyl group, 1,1,2,2-tetrafluoroethyl group, 1,1,2,2,2-pentafluoroethyl group, 1-fluoropropyl group, 2-fluoropropyl group, 1,1-difluoropropyl group, 1,2-difluoropropyl group, 1,3-difluoropropyl group,2,2-difluoropropyl group,1,1,1-trifluoropropyl group, 1,1,2-trifluoropropyl group, 1,2,3-trifluoropropyl group, 1,2,2-trifluoropropyl group, and 1,3,3-trifluoropropyl group.

Examples of the alkoxyl group with 1 to 5 carbon atoms include ethoxyl group, methoxyl group, propoxyl group, isopropoxyl group, butoxyl group, s-butoxyl group, t-butoxyl group, a pentoxyl group.

The aryl group with 6 to 14 carbon atoms includes, for example, phenyl group, a tolyl group, a naphtyl group, a biphenyl group, and an anthryl group.

"n" in formula (1) denotes an integer from 1 to 4. When n is 2, 3, or 4, R¹s bonded to the benzene ring may be the same or different from each other.

Also, Ar¹ and Ar² may be a group represented by formula (3).

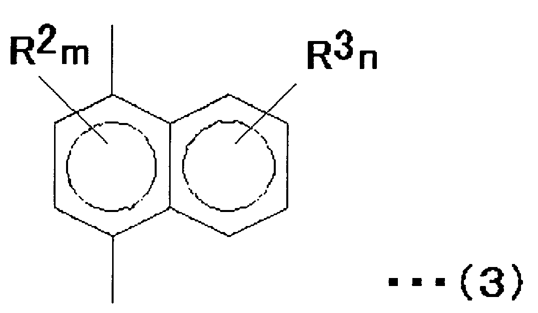

The group represented by formula (3) has a naphthalene ring as its basic skeleton. One of the 1-positioned and 4-positioned carbons of the naphthalene ring is bonded with a carbon atom of the oxadiazole ring and the other with the carbon atom of the methylene ring. The other carbon atoms of the naphthalene ring are bonded with one or two R²s and up to four R³s.

Each of R² and R³ means a hydrogen atom, an alkyl group having 1 to 10 carbon atoms, an alkoxyl group having 1 to 5 carbon atoms, or an aryl having 6 to 14 carbon atoms.

The alkyl group, the alkoxyl group and the aryl group are the same as those explained above.

"m" in formula (3) denotes an integer of 1 or 2, and "n" means the same as that explained above.

Up to two R²s and up to four R³s may be the same or different from each other.

Ar¹ and Ar² may also be a group represented by formula (4).

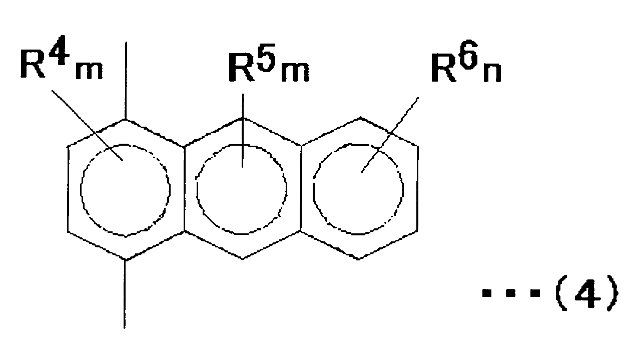

The group represented by formula (4) has an anthracene ring as its basic skeleton. One of the 1-positioned and 4-positioned carbons of the anthracene ring is bonded with a carbon atom of the oxadiazole ring and the other with the carbon atom of the methylene ring. The other carbon atoms of the anthracene ring are bonded with R⁴(s), R⁵(s) and R⁶(s).

Each of R⁴, R⁵, and R⁶ means a hydrogen atom, an alkyl group having 1 to 10 carbon atoms, an alkoxyl group having 1 to 5 carbon atoms, or an aryl having 6 to 14 carbon atoms.

The alkyl group, the alkoxyl group and the aryl group are the same as those explained above.

"m" and "n" mean the same as those explained above.

Up to two R⁴s and R⁵s, and up to four R⁶s may be the same or different from each other.

Furthermore, Ar¹ and Ar² may be a group represented by formula (5).

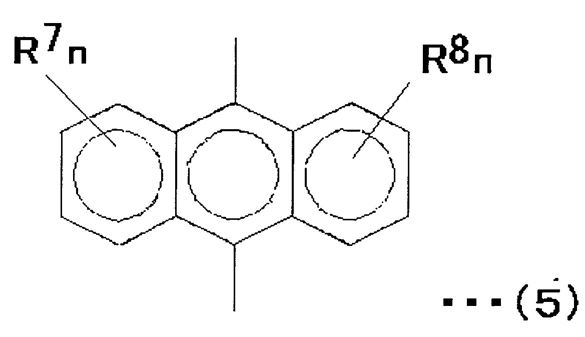

The group represented by formula (5) has an anthracene ring as its basic skeleton. One of the 9-positioned and 10-positioned carbons of the anthracene ring is bonded with a carbon atom of the oxadiazole ring and the other with the carbon atom of the methylene ring. The other carbon atoms of the anthracene ring are bonded with R⁷(s) or R⁸(s).

Each of R⁷ and R⁸ means a hydrogen atom, an alkyl group having 1 to 10 carbon atoms, an alkoxyl group having 1 to 5 carbon atoms, or an aryl having 6 to 14 carbon atoms.

The alkyl group, the alkoxyl group and the aryl group are the same as those explained above.

"n" in formula (5) means the same as that explained above.

Up to four R⁷s and R⁸s of the anthracene ring may be the same or different from each other.

"Z" in formula (1) denotes a single bond or a group represented by formula (6) below.

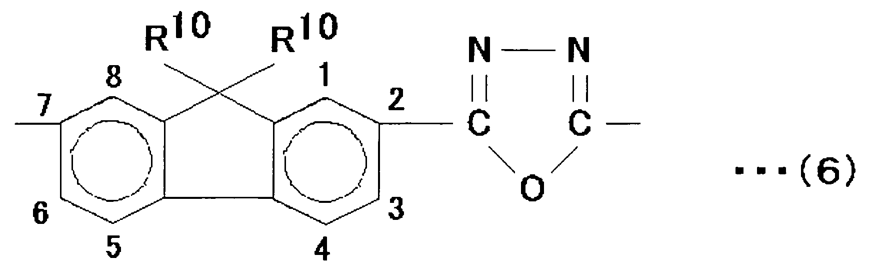

The group represented by formula (6) is composed of a fluorene and an oxadiazole ring.

The 2-positioned carbon atom of the fluorene is bonded with one of the carbon atoms of the oxadiazole ring, and the 7-positioned carbon atom thereof with a carbon atom of Ar² in formula (1). Also, the other carbon atom of the oxadiazole ring is bonded with the Ar¹ in the next repeating unit.

R¹⁰ is a hydrogen atom or an alkyl group having 1 to 10 carbon atoms.

Examples of the alkyl group having 1 to 10 carbon atoms are methyl group, ethyl group, propyl group, isopropyl group, n-butyl group, isobutyl group, sec-butyl group, tert-butyl group, n-pentyl group, sec-pentyl group, tert-pentyl group, a hexyl group, a heptyl group, an octyl group, a nonyl group, a decyl group, etc. Among those are preferred an alkyl group having 1 to 5 carbon atoms, such as methyl group, ethyl group, propyl group, isopropyl group, n-butyl group, isobutyl group, sec-butyl group, tert-butyl group, n-pentyl group, sec-pentyl group, or tert-pentyl group. Alkyl groups having 1 to 3 carbon atoms are particularly preferable.

The alkyl group having 1 to 10 carbon atoms may be a fluorine atom-including alkyl group where at least one of the hydrogen atoms is replaced with a fluorine atom.

For the fluorine atom-including alkyl group with 1 to 10 carbon atoms is preferred a fluorine atom-including alkyl group with 1 to 3 carbon atoms. Examples of the preferred are fluoromethyl group, difluoromethyl group, trifluoromethyl group, fluoroethyl group, 1,1-difluoroethyl group, 1,2-difluoroethyl group, 1,1,1-trifluoroethyl group, 1,1,2-trifluoroethyl group, 1,2,2-trifluoroethyl group, 1,1,2,2-tetrafluoroethyl group, 1,1,2,2,2-pentafluoroethyl group, 1-fluoropropyl group, 2-fluoropropyl group, 1,1-difluoropropyl group, 1,2-difluoropropyl group, 1,3-difluoropropyl group, 2,2-difluoropropyl group,1,1,1-trifluoropropyl group, 1,1,2-trifluoropropyl group, 1,2,3-trifluoropropyl group, 1,2,2-trifluoropropyl group, and 1,3,3-trifluoropropyl group.

Also, the average molecular weight of the blue light-emitting polymer of the present invention is preferably 10000 to 500000, particularly 20000 to 300000.

Because the repeating unit represented by formula (1) has an oxadiazole ring that has a large π electron cloud, the density of the π electron cloud in each repeating unit increases and the π electron cloud becomes stabilized. In these circumstances, it is surmised that blue light can be emitted by the application of a small energy. The blue light-emitting polymer of the present invention is characterized by its repeating unit having the oxadiazole ring with a large π electron cloud, the carbon atoms of which oxadiazole ring are bonded with the groups Ar¹ and Ar². Because this blue light-emitting polymer has a repeating unit that includes aromatic rings and an oxadiazole ring in its backbone chain, it becomes chemically stable, which leads to its special property; it does not easily deteriorate even under severe conditions.

The blue light-emitting polymer of the present invention may be prepared in the following manners.

Specifically, an aromatic compound represented by formula (7) and an aromatic compound with a halogen atom represented by formula (8), which are the starting substances, are heated in a solvent to be subjected to a dehydrohalogenating reaction.
Formula (7) is:

**H-Ar**^{**1**}**-H** **(7)**

wherein Ar¹ denotes the same as the above.
Formula (8) is:

**H-Ar**^{**2**}**-CH**_{**2**}**X** **(8)**

wherein Ar² denotes the same as the above, and "X" denotes a halogen atom. For the halogen atom may be used a chlorine atom, a fluorine atom, a bromine atom, an iodine atom, etc. A chlorine atom is preferable.

The aromatic compound includes, for example, benzene, toluene, o-dimethylbenzene, m-dimethylbenzene, p-dimethylbenzene, o-diethylbenzene, m-diethylbenzene, p-diethylbenzene, naphthalene, 1,2-dimethylnaphthalene, 1,3-dimethylnaphthalene, 1,4-dimethylnaphthalene, 1,2-diethylnaphthalene, 1,3-diethylnaphthalene, 1,4-diethylnaphthalene, and anthracene.

The aromatic compound with a halogen atom includes, for example, benzyl chloride, 1-chloromethylnaphthalene, 2-chloromethylnaphthalene, 1-chloromethylanthracene, 2-chloromethylanthracene, 5-chloromethylanthracene, benzyl bromide, 1-bromomethylnaphthalene, 2-bromomethylnaphthalene, 1-bromomethylanthracene, 2-bromomethylanthracene, and 5-bromomethylanthracene.

The solvent includes an inorganic solvent such as hydrochloric acid, sulfuricacid, or nitric acid, and an organic solvent such as ethanol, methanol, acetic acid, acetic anhydride, dimethyl ether, diethyl ether, acetone, phthalic acid, phthalic anhydride, n-hexane, benzene, toluene, pyridine, tetrahydrofuran, dimethylformamide, which may sometimes be abbreviated to "DMF" hereinafter, and N,N-dimethylacetamide, which may sometimes be abbreviated to "DMAC" hereinafter.

A catalyst may also be employed in this reaction.

For the catalyst may be used, for example, iron, zinc, nickel, copper, platinum, aluminum oxide, or aluminum chloride.

The temperature for the dehydrohalogenation reaction should be from 80 to 100°C, preferably from 85 to 95°C.

The dehydrohalogenation reaction produces a compound represented by formula (12) below.

**H-Ar**^{**1**}**-CH**_{**2**}**-Ar**^{**2**}**-H** **(12)**

The compound represented by formula (12) is heated with an acyl halide represented by formula (13) in a solvent, so that the compound is acetylated.

**R**^{**11**}**CO-X** **(13)**

wherein R¹¹ in formula (13) denotes an alkyl group with 1 to 5 carbon atoms.

Examples of the alkyl group with 1 to 5 carbon atoms include methyl group, ethyl group, propyl group, isopropyl group, n-butyl group, isobutyl group, sec-butyl group, tert-butyl group, n-pentyl group, sec-pentyl group, and tert-pentyl group. Among them, an alkyl group with 1 to 3 carbon atoms is preferable.

"X" in formula (13) denotes a halogen atom, which includes a chlorine atom, a fluorine atom, a bromine atom, and an iodine atom. A chlorine atom is preferable.

For the acyl halide may be used acetyl chloride, propionyl chloride, butyryl chloride, isobutyryl chloride, acetyl bromide, propionyl bromide, butyryl bromide, isobutyryl bromide, etc.

Examples of the solvent include inorganic solvents such as carbon sulfide or carbon disulfide, and organic solvents such as ethanol, methanol, acetic anhydride, phthalic anhydride, diethyl ether, dimethyl ether, acetone, benzene, toluene, pyridine, tetrahydrofuran, DMF, and DMAC.

A catalyst may also be employed in this reaction.

For the catalyst may be used aluminum chloride, antimony chloride, lead chloride, titanium chloride, bismuth chloride, or zinc chloride.

The temperature for the acetylating reaction is typically from 20 to 50°C, preferably from 30 to 40°C.

The acetylating reaction produces a compound represented by formula (14).

**R**^{**11**}**CO-Ar**^{**1**}**-CH**_{**2**}**-Ar** ^{**2**}**-COR**^{**11**} **(14)**

Then, the compound represented by formula (14) is subjected to an oxidization reaction by heating it with an oxidizing agent in a solvent.

The solvent includes, for example, non-polar solvents such as benzene, carbon tetrachloride, hexane, diethyl ether, and dimethyl ether, and polar solvents such as methanol, ethanol, pyridine, tetrahydrofuran, DMF, and DMAC. It is preferable if the solvent for this oxidization reaction is the same as that used for the acetylating reaction. If so, the oxidization can be carried out directly after the completion of the acetylation, by adding the oxidizing agent to the product liquid of the acetylation and heating the obtained mixture.

Examples of the oxidizing agent include sodium hypochlorite are potassium hypochlorite.

The reaction temperature for the oxidization reaction is typically from 40 to 80°C, preferably from 60 to 70°C.

The oxidization reaction produces a carbonyl compound represented by formula (15).

**MCO-Ar**^{**1**}**-CH**_{**2-**}**Ar**^{**2**}**-COM** **(15)**

"M" in formula (15) denotes the element originating from the oxidizing agent. Therefore "M" is, for example, sodium or potassium.

Hydrolysis of the carbonyl compound represented by formula (15) in the presence of an acid or an alkali produces a dicarboxylic acid represented by formula (9).

**HOOC-Ar**^{**1**}**-CH**_{**2**}**-Ar**^{**2**}**-COOH** **(9)**

For the acid may be employed hydrochloric acid, sulfuric acid, or nitric acid. For the alkali, sodium hydroxide, potassium hydroxide, calcium hydroxide, magnesium hydroxide, or ammonia may be used.

Then, the dicarboxylic acid and a hydrazinium salt are subjected to condensation-polymerization by heating them in the presence of a dehydrating agent.

Examples of the dehydrating agent include sulfuric acid, zinc chloride, phosphoric acid anhydride, boric acid, oxalic acid, or polyphosphoric acid.

Examples of the hydrazinium salt include hydrazine hydrochloride, hydrazine sulfate and hydrazine nitrate.

The reaction temperature for the condensation-polymerization is typically from 100 to 150°C, preferably from 110 to 130°C.

This reaction results in the blue light-emitting polymer of the present invention represented by formula (1).

Another process of producing the blue light-emitting polymer of the present invention is as follows.

A fluorene represented by formula (10) and an acyl halide represented by formula (13) are heated in a solvent, so that the fluorene is acetylated.

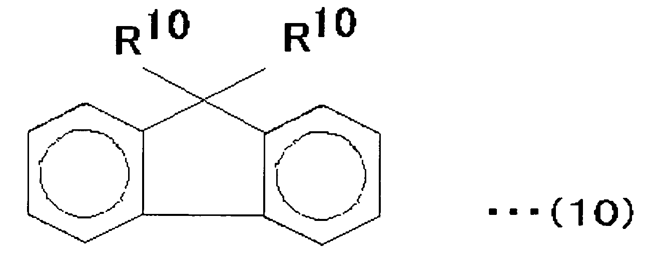

In formula (10), R¹⁰ denotes a hydrogen atom, or an alkyl group with 1 to 10 carbon atoms, preferably with 1 to 5 carbon atoms, more preferably 1 to 3 carbon atoms. The alkyl group includes those examples that have been mentioned above.

**R**^{**11**}**CO-X** **(13)**

In formula (13), R¹¹ denotes a hydrogen atom, or an alkyl group with 1 to 5 carbon atoms.

Examples of the alkyl group with 1 to 5 carbon atoms include methyl group, ethyl group, propyl group, isopropyl group, n-butyl group, isobutyl group, sec-butyl group, tert-butyl group, n-pentyl group, sec-pentyl group, and tert-pentyl group. Among them are preferred alkyl groups with 1 to 3 carbon atoms.

"X" in formula (13) denotes a halogen atom, which includes a chlorine atom, a fluorine atom, a bromine atom, and an iodine atom. A chlorine atom is preferable.

For the acyl halide may be used acetyl chloride, propionyl chloride, butyryl chloride, isobutyryl chloride, acetyl bromide, propionyl bromide, butyryl bromide, isobutyryl bromide, etc. An acyl chloride is preferable. More preferable is an acyl chloride with 1 to 3 carbon atoms.

Examples of the solvent include inorganic solvents such as carbon sulfide or carbon disulfide, and organic solvents such as ethanol, methanol, acetic anhydride, phthalic anhydride, diethyl ether, dimethyl ether, acetone, benzene, toluene, pyridine, tetrahydrofuran, DMF, and DMAC.

A catalyst may also be employed in this reaction.

For the catalyst may be used, for example, aluminum chloride, antimony chloride, lead chloride, titanium chloride, bismuth chloride, or zinc chloride.

The temperature for the acetylating reaction is typically from 20 to 50°C, preferably from 30 to 40°C.

The acetylating reaction produces a compound represented by formula (16).

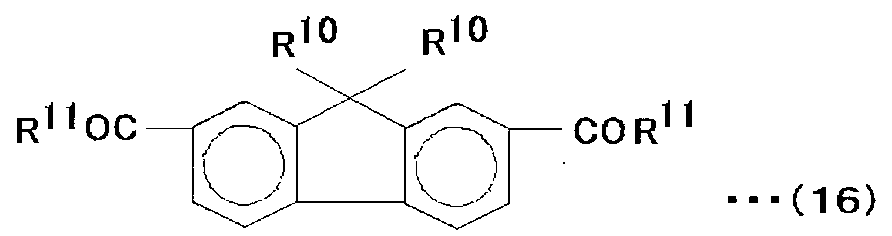

Then, the compound represented by formula (16) is subjected to an oxidization reaction by heating it with an oxidizing agent in a solvent.

The solvent includes, for example, non-polar solvents such as benzene, carbon tetrachloride, hexane, diethyl ether, and dimethyl ether, and polar solvents suchasmethanol, ethanol, pyridine, tetrahydrofuran, DMF, and DMAC.

Examples of the oxidizing agent include sodium hypochlorite are potassium hypochlorite.

The reaction temperature for the oxidization reaction is typically from 40 to 80°C, preferably from 60 to 70°C.

The oxidization reaction produces a carbonyl compound represented by formula (17).

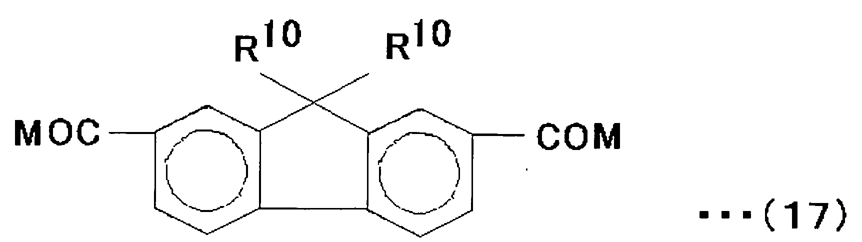

"M" in formula (17) denotes the element originating from the oxidizing agent. Therefore "M" is, for example, sodium or potassium.

Hydrolysis of the carbonyl compound represented by formula (17) in the presence of an acid or an alkali produces a dicarboxylic acid represented by formula (11).

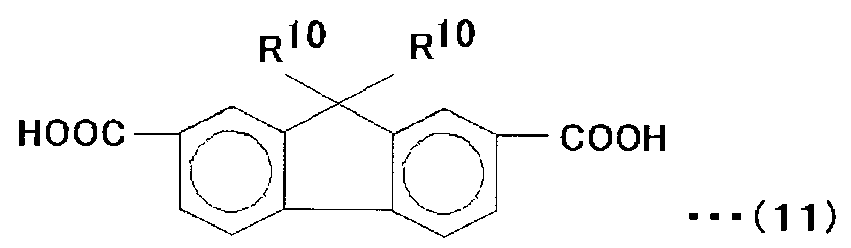

For the acid may be employed hydrochloric acid, sulfuric acid, or nitric acid. For the alkali, sodium hydroxide, potassium hydroxide, calcium hydroxide, magnesium hydroxide, or ammonia may be used.

Then, the dicarboxylic acid and a hydrazinium salt are subjected to condensation-polymerization by heating them in the presence of a dehydrating agent.

Examples of the dehydrating agent include sulfuric acid, zinc chloride, phosphoric acid anhydride, boric acid, oxalic acid, or polyphosphoric acid.

Examples of the hydrazinium salt include hydrazine hydrochloride, hydrazine sulfate and hydrazine nitrate.

The reaction temperature for the condensation-polymerization is typically from 100 to 150°C, preferably from 110 to 130°C.

This reaction results in the blue light-emitting polymer of the present invention represented by formula (1).

The luminescent element utilizing the blue light-emitting polymer of the present invention will be explained in the followings.

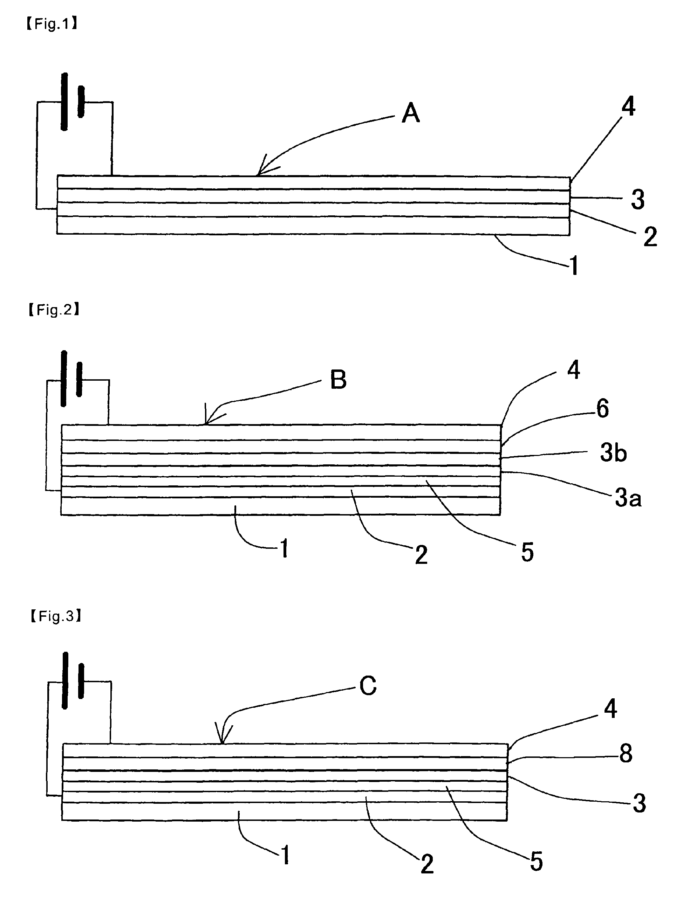

Figure 1 is a schematic illustration that shows the sectional structure of a luminescent element according to the present invention, which is a one-layer type organic EL element. As shown in this figure, the luminescent element A is prepared by layering a light-emitting layer 3 that includes a light-emitting substance and an electrode layer 4 in this order on a substrate 1 with which a transparent electrode 2 has been provided.

When the luminescent element shown in Figure 1 includes a blue light-emitting polymer of the present invention, a red light-emitting compound and a green light-emitting compound at a balanced composition, it emits white light upon the application of electricity through the transparent electrode 2 and the electrode layer 4. The total amount of the blue light-emitting polymer of the present invention, the red light-emitting compound and the green light-emitting compound, and the proportion of the amount of the blue light-emitting polymer to that of the red light-emitting compound to that of the green light-emitting compound, included in the layer 3 to let the element emit white light, vary depending on the kind of each compound and polymer. They are decided for each luminescent element depending on the kind of each compound and polymer included therein. When the luminescent element is intended to emit blue light, the light-emitting layer 3 may include only a blue light-emitting polymer of the present invention. Also, when this luminescent element is intended to emit light of any color other than white and blue, the total amount of the polymer and compounds and their respective amounts should be changed depending on the color. For example, when the luminescent element including a blue light-emitting polymer of this invention is intended to emit white light, the ratio of the amount of the blue light-emitting polymer to that of the red light-emitting compound to that of the green light-emitting compound is usually 5-200:10-100:50-20000 in weight, preferably 10-100:50-500: 100-10000.

For the red-light emitting compound is suitable the Nile Red luminescent compound emitting red light represented by formula (18).

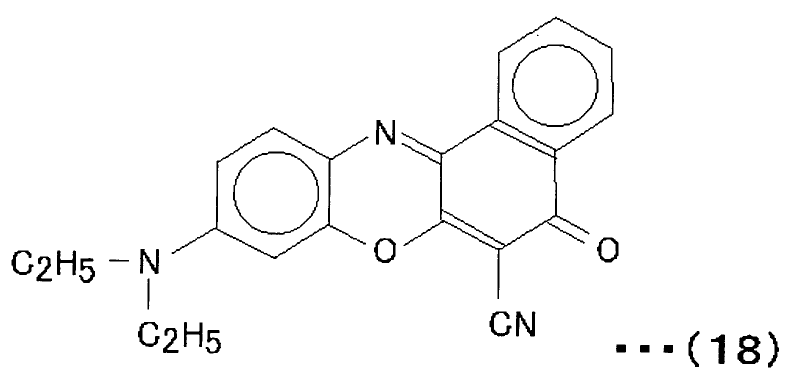

For the green light-emitting compound is suitable a coumarone compound emitting green light, an indophenol compound emitting green light and an indigo compound emitting green light. The coumarin compound represented by the formula (19) is preferable among them.

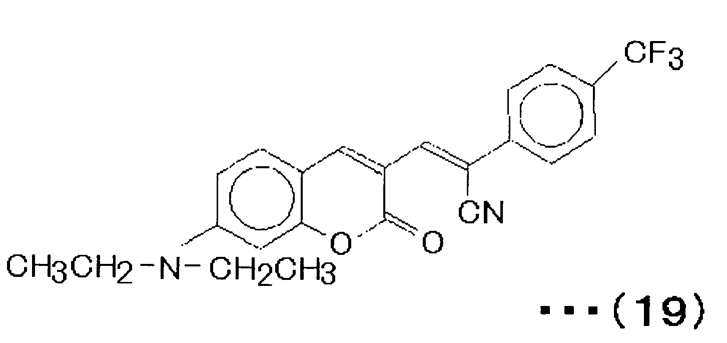

When an electric field is applied between the transparent electrode 2 and the electrode layer 4, electrons are injected from the electrode layer 4 and positive holes are injected from the transparent electrode 2. In the light-emitting layer 3, the electrons are recombined with positive holes, which causes the energy level to return to the valence band from the conduction band. This transition of the energy level is accompanied by emission of the energy differential as light.

The luminescent element A shown in Figure 1, when it is shaped to a planar form with a large area, may be used as a planar illuminator, for example a large-area wall illuminator when fixed on a wall, or a large-area ceiling illuminator when fixed on a ceiling. This luminescent element may be utilized for a planar light source in place of a point light source, such as a conventional bulb, and a line light source, such as a conventional fluorescent lamp. In particular, this illuminator can suitably be used to light up walls, ceilings and floors in dwelling rooms, offices and passenger trains, or to make them emit light. Moreover, this luminescent element A may be suitable for the backlight used in the displays of computers, cellular phones and ATMs. Furthermore, this illuminator may be used for various light sources, such as the light source of direct illumination and that of indirect illumination. Also, it may be used for the light sources of advertisement apparatuses, road traffic sign apparatuses and light-emitting billboards, which have to emit light at night and provide good visibility. In addition, because this luminescent element A includes a blue light-emitting polymer of the present invention, which has the specific chemical structure, in the light-emitting layer, the luminescent element A may have a long life. Therefore, light sources employing the luminescent element A will naturally have a long life.

As understood from the foregoing, when the light-emitting layer of the luminescent element A includes a blue light-emitting polymer of the present invention and not a red light-emitting compound or a green light-emitting compound, the luminescent element A emits clear blue light.

The luminescent element A may also be shaped into a tubular light emitter comprising a tubularly shaped substrate 1, a transparent electrode 2 placed on the internal surface of the substrate 1, a light emitting layer 3 and an electrode layer 4 placed on the transparent electrode 2 in this order. Because the luminescent element A does not include mercury, it is an ecological light source and may be a substitute for conventional fluorescent lamps.

For the substrate 1 may be used any known substrate, as long as the transparent electrode 2 can be formed on the surface of the substrate. Examples of the substrate 1 are a glass substrate, a plastic sheet, a ceramic substrate, and a metal substrate whose surface is insulated, for example, by forming thereon a layer of an insulating paint.

When the substrate 1 is opaque, the luminescent element, which includes a red light-emitting compound, a green light-emitting compound and a blue light-emitting polymer of the present invention, is a single-faced illuminator that emits white light from the surface layer opposite to the substrate. On the other hand, when the substrate 1 is transparent, the luminescent element is a double-faced illuminator that emits white light from both of the substrate and the surface layer opposite to the substrate.

For the transparent electrode 2, various materials may be employed, as long as their work functions are large, they are transparent, and they can function as a cathode and inject holes to the light-emitting layer 3 when voltage is applied thereto. Specifically, the transparent electrode 2 may be made of a transparent inorganic conductive material of ITO, In₂O₃, SnO₂ ZnO, CdO, etc. and derivatives thereof, or an electrically conductive high polymer such as polyaniline.

The transparent electrode 2 may be formed on the substrate 1 by chemical vapor phase deposition, spray pyrolysis, high-vacuum metal deposition, electron beam deposition, sputtering, ion beam sputtering, ion plating, ion-assisted deposition, and other methods.

When the substrate is made of an opaque material, the electrode formed on the substrate need not be transparent.

The light-emitting layer 3 is a layer that includes a blue light-emitting polymer according to the present invention when the layer 3 is intended to emit blue light. It includes a red light-emitting compound and a green light-emitting compound in addition to a blue light-emitting polymer of the present invention when it is intended to emit white light. A film of a blue light-emitting polymer of the present invention, or a film of a red light-emitting compound, a green light-emitting compound, and a blue light-emitting polymer of the present invention may be formed on the transparent electrode 2.

A typical way of forming a film of the blue light-emitting polymer on the transparent electrode 2 may be the application of a solution of the polymer dissolved in a suitable solvent onto the transparent electrode. The application method includes, for example, a spin cast method, a brush-coating method, etc.

The thickness of the light-emitting layer 3 ranges, typically between 30 nm and 500 nm, preferably between 100 nm and 300 nm. When the thickness is too small, the amount of the emitted light may be insufficient. On the other hand, when the thickness is too large, the voltage required to drive the element may be too high, which is not desirable. Besides, the large thickness may reduce the flexibility of the film necessary to be shaped into a planar, tubular, curved, or ring article.

For the electrode layer 4 may be employed a material having a small work function. Examples of the material are elementary metals and metallic alloys, such as MgAg, aluminum alloy, metallic calcium, etc. A preferable electrode layer 4 is made of an alloy of aluminum and a small amount of lithium. This electrode layer 4 may easily be formed on the surface of light-emitting layer 3, which, in turn, has been formed on substrate 1, by the technique of metal deposition.

When the light-emitting layer is formed, a buffer layer should be inserted between each electrode and the light-emitting layer.

Materials for the buffer layer are, for example, an alkaline metal compound such as lithium fluoride, an alkaline earth metal compound such as magnesium fluoride, an oxide such as an aluminum oxide, and 4, 4'-biscarbazole biphenyl (Cz-TPD) . Also-, materials for forming the buffer layer between the cathode made of, for example, ITO, and the organic layer include m-MTDATA (4,4',4"-tris(3-methylphenyl-phenylamino)triphenylamine), phthalocyanine, polyaniline, and polythiophene derivatives, and inorganic oxides such as molybdenum oxide, ruthenium oxide, vanadium oxide, and lithium fluoride. When the materials are appropriately selected, these buffer layers can lower the driving voltage of the organic EL element, improve the quantum efficiency of luminescence, and achieve an increase in the luminance of the emitted light.

Next, the second example of the luminescent element according to the present invention is shown in Figure 2. This figure is an illustration showing the sectional layer structure of a luminescent element, which is a multi-layer organic EL element.

As shown in Figure 2, the luminescent element B comprises a substrate 1, and a transparent electrode 2, a hole-transporting layer 5, light-emitting sublayers 3a and 3b, an electron-transporting layer 6, and an electrode layer 4, the layers being laid on the substrate 1 one by one in this order.

The substrate 1, the transparent electrode 2 and the electrode layer 4 are the same as those explained for the luminescent element A in Figure 1.

The light-emitting layer of the luminescent element B comprises light-emitting sublayers 3a and 3b. The light-emitting sublayer 3a is a deposited film formed by depositing a light-emitting compound on the hole-transporting layer 5. The light-emitting sublayer 3b functions as a host material.

Examples of the hole-transporting substance included in the hole-transporting layer 5 are a triphenylamine compound such as N,N'-diphenyl-N,N'-di(m-tolyl)-benzidine (TPD) and α-NPD, a hydrazon compound, a stilbene compound, a heterocyclic compound, a π electron star burst positive hole transporting substance, etc.

Examples of the electron-transporting substance included in the electron-transporting layer 6 are an oxadiazole derivative such as 2-(4-tert-butylphenyl)-5-(4-biphenylyl)-1,3,4-oxadiazole and 2,5-bis(1-naphthyl)-1,3,4-oxadiazole (BND), and2,5-bis(5'-tert-butyl-2'-benzoxazolyl) thiophene. Also, a metal complex material such as quinolinol aluminum complex (Alq3), benzoquinolinol beryllium complex (Bebq2) may be used suitably.

The electron-transporting layer 6 of the luminescent element B shown in Figure 2 includes Alq3 as electron-transporting substance.

The thickness of each layer is the same as that in a known multi-layer organic EL element.

The luminescent element B in Figure 2 functions and emits light in the same ways as the luminescent element A in Figure 1. Therefore, the luminescent element B has the same uses as the luminescent element A.

The third example of the luminescent element of this invention is shown in Figure 3. This figure is an illustration showing the sectional layer structure of a luminescent element, which is a multi-layer organic EL element.

The luminescent element C shown in Figure 3 comprises a substrate 1, and a transparent electrode 2, a hole-transporting layer 5, a light-emitting layer 3, an electron-transporting layer 8, and an electrode layer 4, wherein the transparent electrode and the layers are laid on substrate 1 one by one in this order.

The luminescent element C functions in the same way as the luminescent element B.

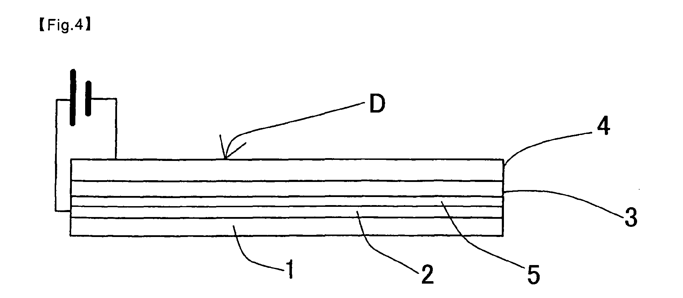

Another example of the luminescent element of this invention is shown in Figure 4. The luminescent element D comprises a substrate 1, and a transparent electrode 2, a hole-transporting layer 5, a light-emitting layer 3, and an electrode layer 4 wherein the transparent electrode and the layers are laid on the substrate 1 one by one in this order.

An example of the luminescent elements, other than those shown in Figures 1-4, is a two-layer low molecular weight organic luminescent element having a hole-transporting layer that includes a hole-transporting substance and an electron-transporting luminescent layer that includes a blue light-emitting polymer of the present invention laid on the hole-transporting layer, these layers being sandwiched between a cathode, which is the transparent electrode formed on the substrate, and an anode, which is the electrode layer. A specific example of this embodiment is a two-layer pigment-injected luminescent element comprising a hole-transporting layer and a luminescent layer that includes a host pigment and a blue light-emitting polymer of this invention as a guest pigment, wherein the luminescent layer is laid on the hole-transporting layer and these layers are sandwiched between the cathode and the anode. Another example is a two-layer organic luminescent element comprising a hole-transporting layer that includes a hole-transporting substance and an electron-transporting luminescent layer that is prepared through co-deposition of a blue light-emitting polymer of the present invention and an electron-transporting substance, the latter layer being laid on the former, and these two layers being sandwiched between the cathode and the anode. A specific example of the second embodiment is a two-layer pigment-injected luminescent element comprising a hole-transporting layer and an electron-transporting luminescent layer that includes a host pigment and a blue light-emitting polymer of this invention as a guest pigment, wherein the luminescent layer is laid on the hole-transporting layer and these layers are sandwiched between the cathode and the anode. A further example is a three-layer organic luminescent element comprising a hole-transporting layer, a luminescent layer including a blue light-emitting polymer of this invention that is laid on the hole-transporting layer, and an electron-transporting layer that is laid on the luminescent layer, these layers being sandwiched between the cathode and the anode.

Also, it is preferred if the light-emitting layer includes, as a sensitizing agent, rubrene, especially rubrene together with Alq3.

A blue light-emitting element utilizing a blue light-emitting polymer of the present invention, or a white light-emitting element utilizing a red light-emitting compound, a green light-emitting compound and a blue light-emitting polymer of the present invention may generally be used for an organic EL element driven by direct current, and also by pulses and alternating current.

### EXAMPLES

### (Example 1)

### - Synthesis of a Blue Light-emitting Polymer -

### <Dehydrohalogenation>

In a 2L three-necked flask were placed 100 g of naphthalene, 148.14 g of benzyl chloride, and 40.82 g of zinc. The flask containing the mixture was placed in a water bath and the mixture was heated to 90°C. The mixture was stirred for 1.5 hours at around the temperature and allowed to react. After the termination of the reaction, the product was cooled with ice. The cooled product was subjected to extraction with benzene. The extraction/separation was carried out four times. 375 ml of benzene was used each time. The extract was washed with water four times, which was followed by a filtration. The solids collected were dissolved in 2L of benzene, and the resulting solution was vacuum distilled for an hour at 80°C with an evaporator. After the distillation, ethanol was added to the obtained concentrate. The resultant was heated to 60°C, then cooled naturally, and filtered. 62.38 g of white crystals were obtained.

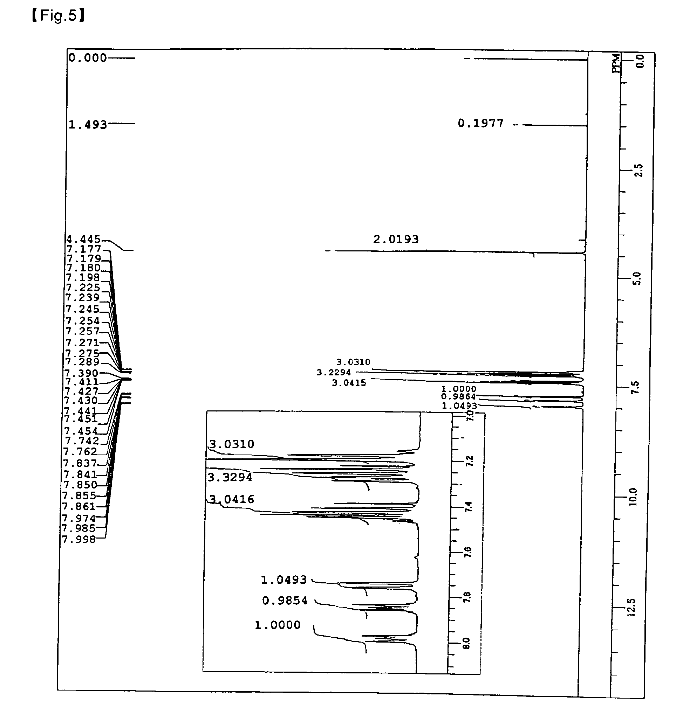

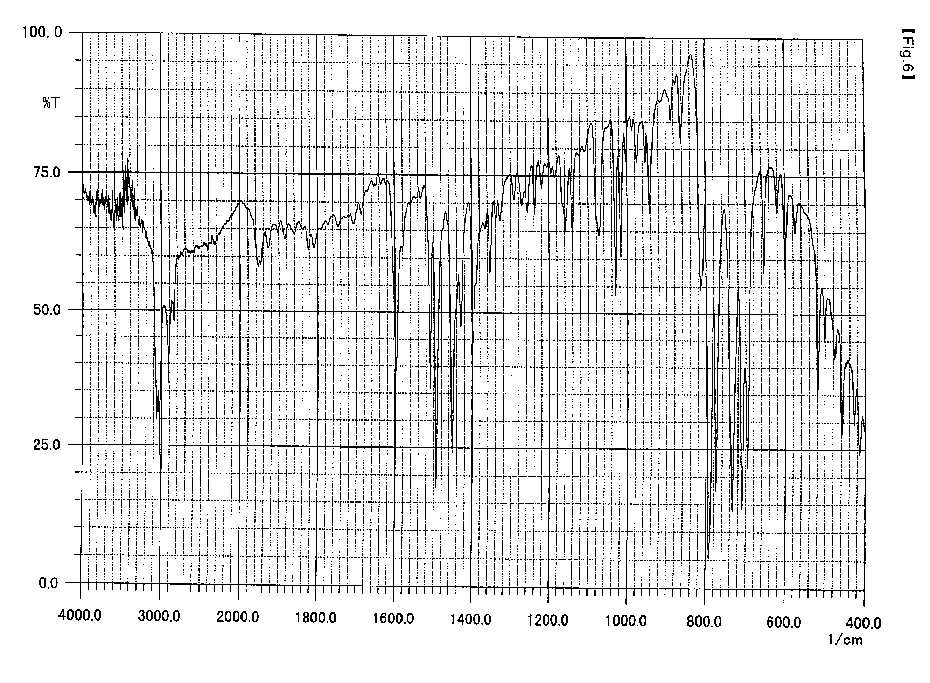

An NMR spectrum chart of the white crystals is shown in Figure 5 and an IR spectrum chart thereof in Figure 6. These white crystals were identified as the compound having the structure represented by formula (20).

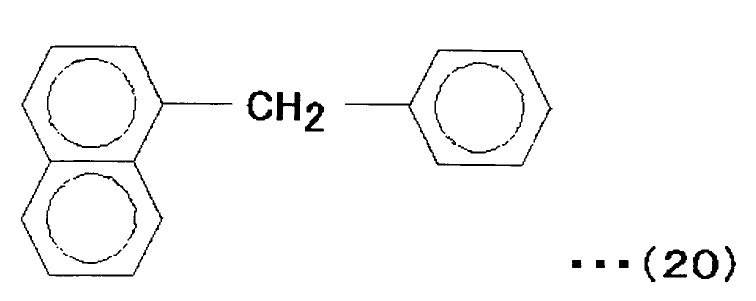

### <Acetylation>

In a 1L three-necked flask were placed 32.55 g of the compound obtained in the step of dehydrohalogenation, 116.35 g of acetyl chloride, 197.7 g of aluminum chloride, and 167 ml of carbon disulfide. The flask containing the mixture was placed in a water bath and the mixture was heated to 35°C. The mixture was stirred for 2.5 hours at around the temperature and allowed to react. After the termination of the reaction, the product was cooled naturally. The cooled product was subjected to extraction with chloroform. The extraction/separation was carried out three times. 80 ml of chloroform was used each time. Then, the extract was washed with water four times. The solvent was distilled away from the washed extract and the remaining was dried up to solids. The solids were introduced into 75 ml of dioxane, and the resulting mixture was filtered. The solids collected were dissolved in a mixed solvent of dioxane and petroleum ether, and the resultant solution was dried up. 26.77 g of yellow crystals were obtained.

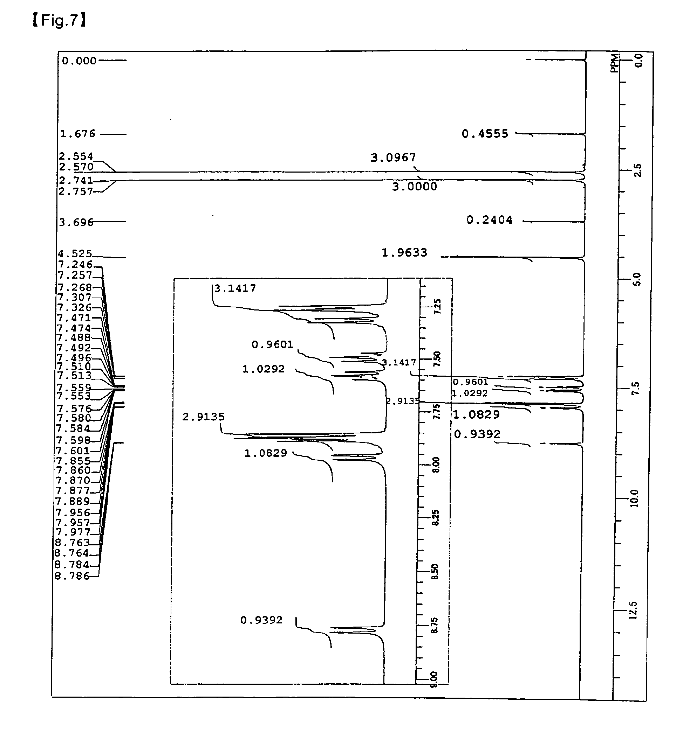

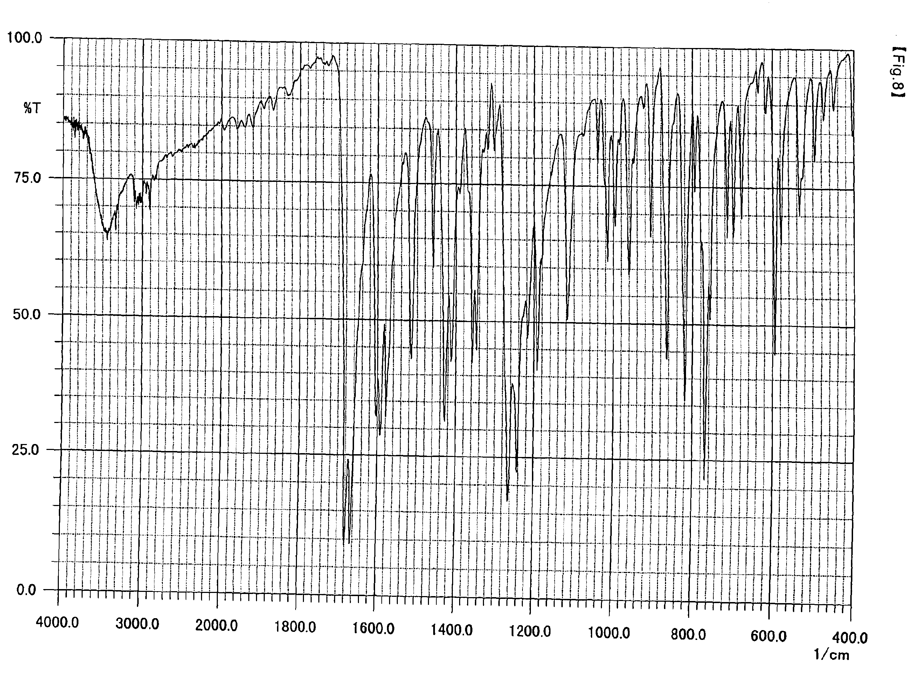

An NMR spectrum chart of the yellow crystals is shown in Figure 7 and an IR spectrum chart thereof in Figure 8. These yellow crystals were identified as the compound having the structure represented by formula (21).

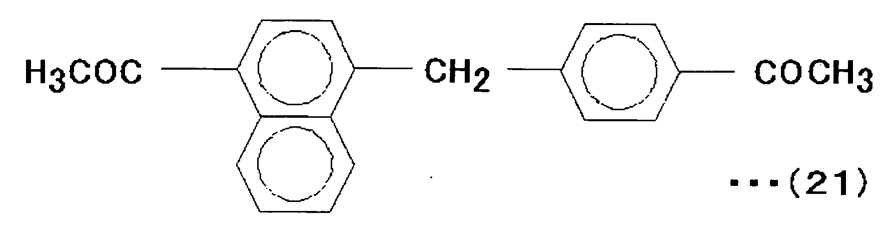

### <Oxidation and Hydrolysis>

In a 2L three-necked flask were placed 26.77 g of the compound produced in the step of acetylation and 40 ml of methanol. The flask containing the mixture was placed in a water bath and the mixture was heated up to 65°C step by step. A 0.7 mol/L aqueous solution of sodium hypochlorite was gradually added to the mixture during the stepwise process of heating. The total amount of the added was 500 ml. The resulting mixture was stirred for 2 hours at 65°C and allowed to react. After the termination of the reaction, the product was cooled naturally. The cooled product was filtered, and the solids collected were washed with water and then with 25 ml of methanol. The washed was dried. 21.44 g of white crystals were obtained.

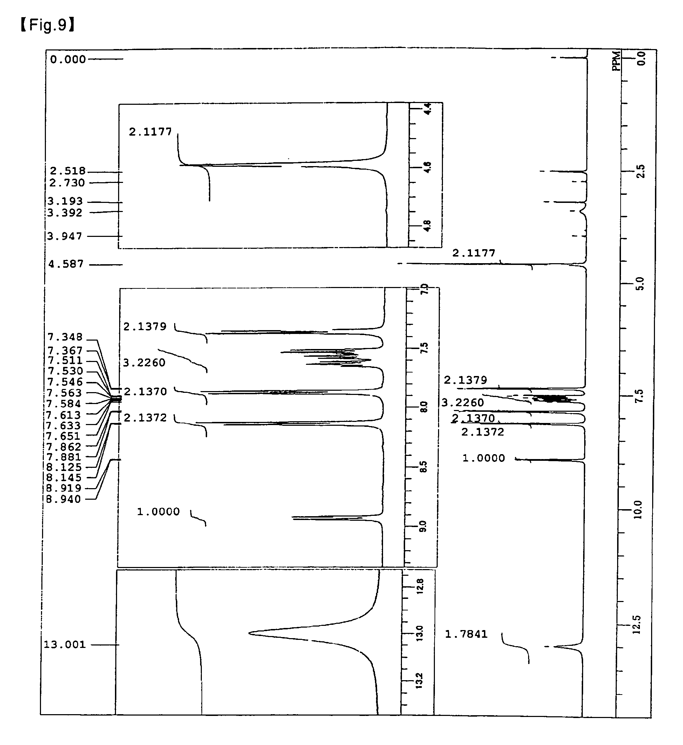

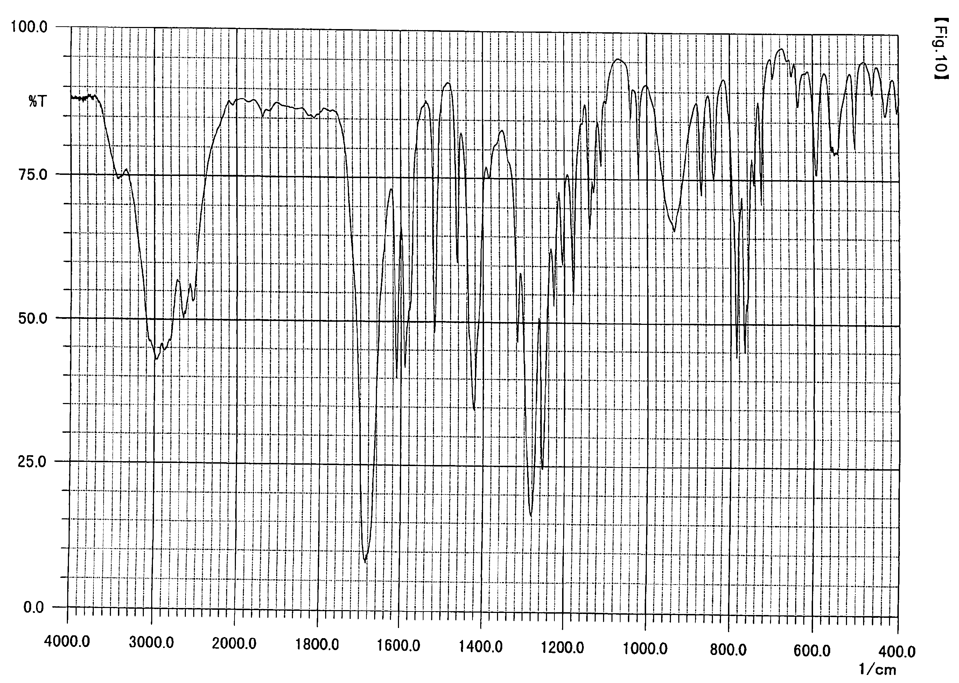

An NMR spectrum chart of the obtained crystals is shown in Figure 9 and an IR spectrum chart thereof in Figure 10. These white crystals were identified as the dicarboxylic acid having the structure represented by formula (22).

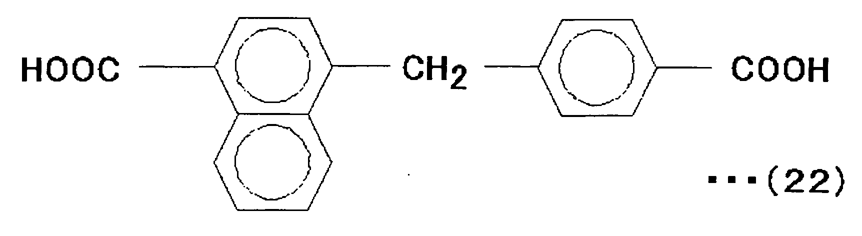

### <Condensation-polymerization>

In a 2L three-necked flask were placed 3.0 g of the dicarboxylic acid produced through the oxidation and hydrolysis, 49 g of polyphosphoric acid, and 1.27 g of hydrazine sulfate. The flask containing the mixture was placed in an oil bath and the mixture was heated to 120°C. The mixture was stirred for 6. 5 hours at around the temperature and allowed to react. After the termination of the reaction, the product was cooled with ice. The cooled product was subjected to extraction with DMAC using a Soxhlet abstractor. The resulting extract was concentrated, and the concentrate was filtered. The filtrate was taken, and the solvent was removed from the filtrate. A film having stringiness was obtained.

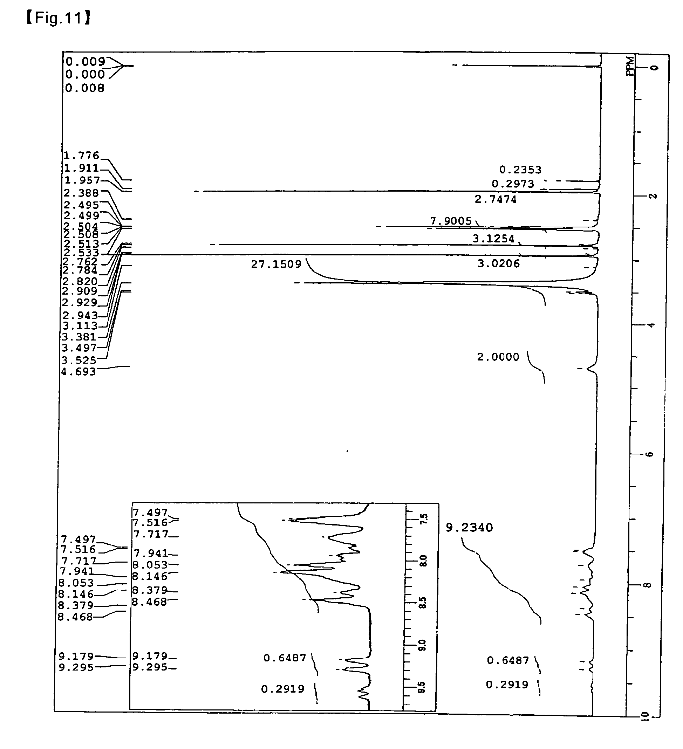

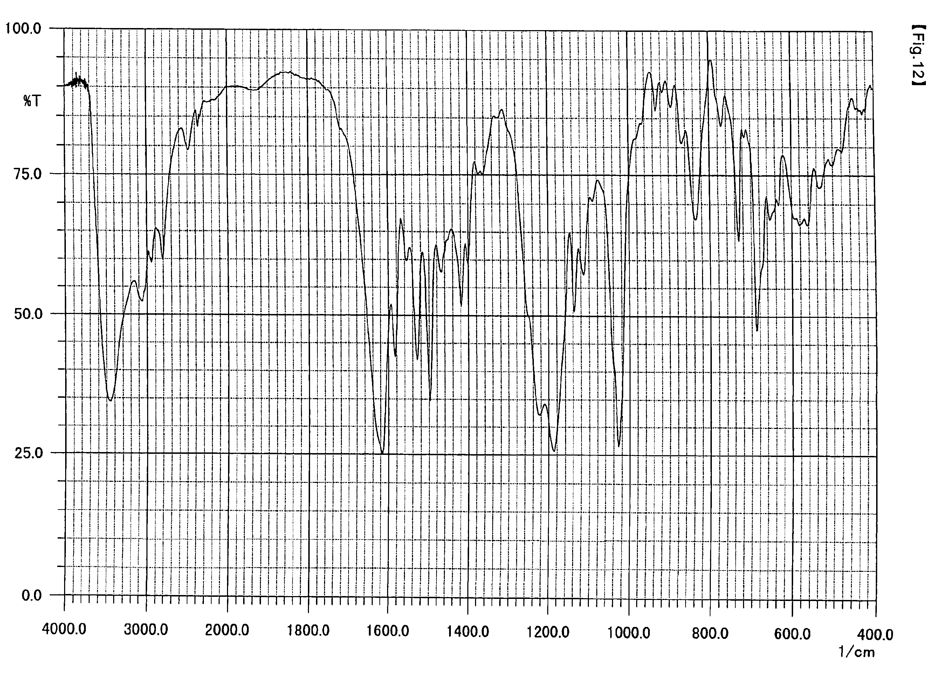

An NMR spectrum chart of the obtained film is shown in Figure 11 and an IR spectrum chart thereof in Figure 12. This film was identified as the polymer having the structure represented by formula (23).

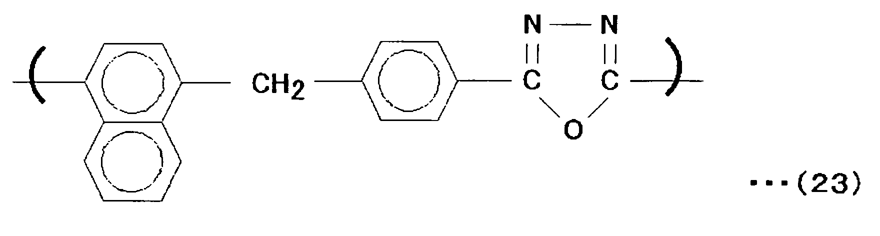

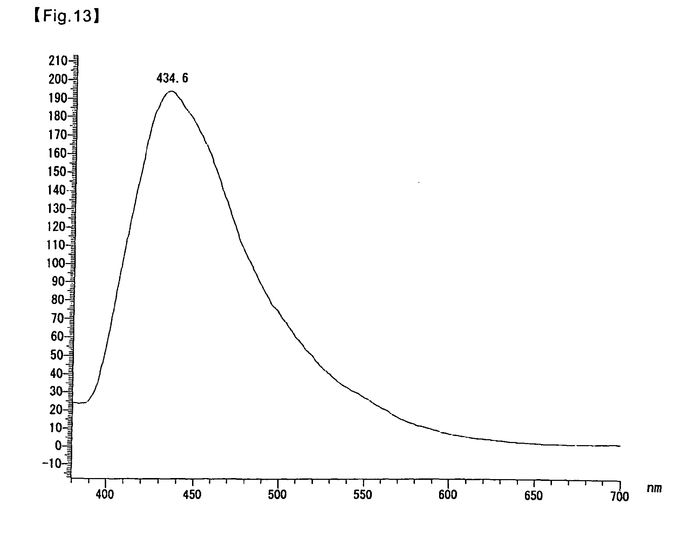

The obtained film was loaded in a model F-4500 spectrofluorophotometer, a product by Hitachi, Ltd., and the fluorescence spectrum of the film was measured under the following conditions. The measured spectrum is shown in Figure 13.
Conditions of Measurement
Measuring mode: Wavelength scanning
Exciting wavelength: 365 nm
Wavelength at which the emission of fluorescence started: 380 nm
Wavelength at which the emission of fluorescence ended: 700 nm
Scanning speed: 2400 nm/min.
Slit on the side of excitation: 5.0 nm
Slit on the side of fluorescence emission: 5.0 nm
Photomal voltage: 700 V

As understood from Figure 13, the film obtained in this working example has a peak ranging from 400 nm to 500 nm. It means that the film emits blue light.

### (Example 2)

### - Synthesis of a Blue Light-emitting Polymer -

### <Condensation-polymerization>

In a 2L three-necked flask were placed 1.0 g of the dicarboxylic acid represented in formula (22), which had been prepared in Example 1, 0.92 g of a commercial fluorene represented by formula (25) below, 0.84 g of hydrazine sulfate, and 60 g of polyphosphoric acid.

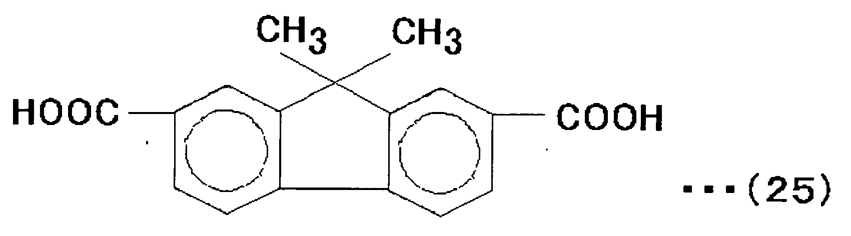

The flask containing the mixture was placed in an oil bath and the mixture was heated to 107°C. The mixture was stirred for 48 hours at around the temperature and allowed to react. After the termination of the reaction, the product solution was poured into pH-9 water so that solids were formed. From the solids only white solids were taken, and the white solids were dissolved in 150 ml of DMAC, which is the abbreviation of N,N-dimethylacetamide. The resultant solution was heated to 180°C and refluxed at around the temperature for 12 hours. Then, the refluxed was cooled naturally and filtered. The filtrate obtained was vacuum dried. A film was obtained.

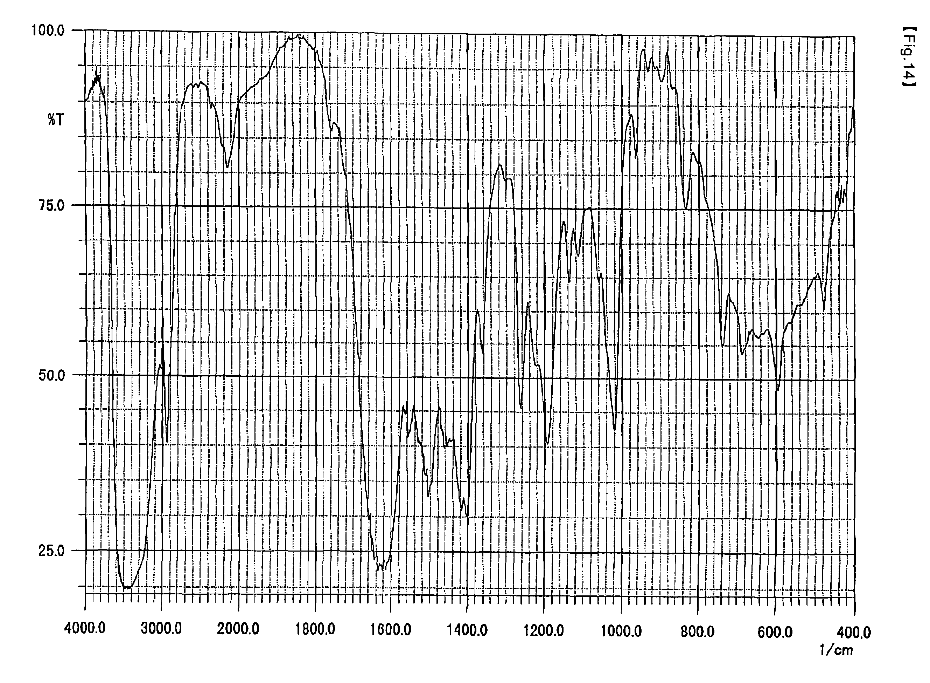

An IR spectrum chart of the obtained film is shown in Figure 14. This film was identified as the polymer having the structure represented by formula (26).

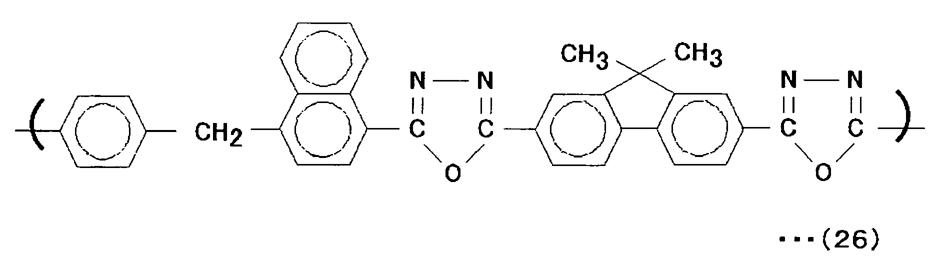

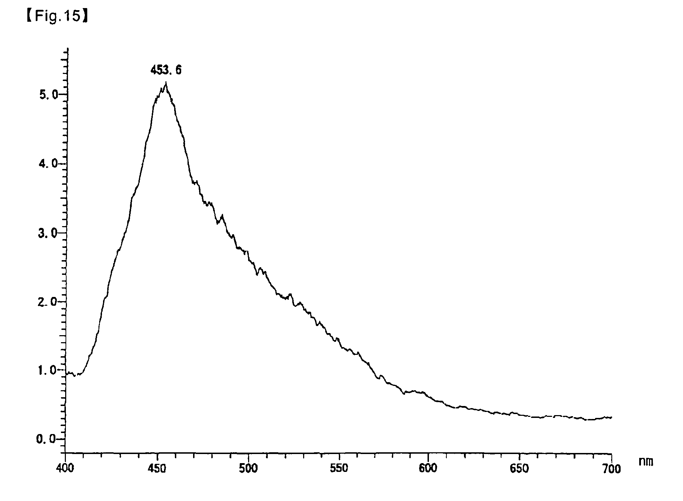

A sample solution was prepared by dissolving 100 mg of the obtained film in 5 ml of DMAC. This sample solution was loaded in a model F-4500 spectrofluorophotometer, a product by Hitachi, Ltd., and the fluorescence spectrum of the film was measured under the same conditions as that of the film produced in Example 1 was measured. The measured spectrum is shown in Figure 15.

As understood from Figure 15, the film obtained in this working example has a peak ranging from 400 nm to 450 nm. It means that the film emits blue light.

### INDUSTRIAL APPLICABILITY

The present invention provides a blue light-emitting polymer capable of emitting blue light at a high luminance for a long time, processes of producing the polymer and luminescent elements including the blue light-emitting polymer.

## Claims

1. A blue light-emitting polymer having a repeating unit represented by formula (1): 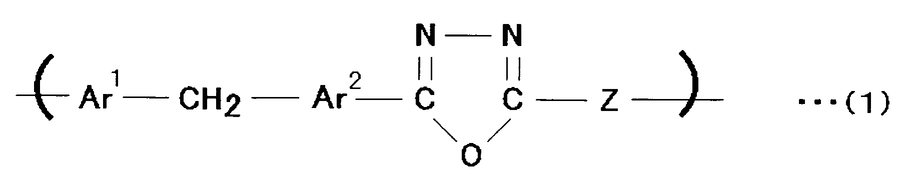 wherein each of Ar¹ and Ar² denotes a group represented by formula (2), (3), (4) or (5), wherein Ar¹ and Ar² may be the same or different from each other; Z is a single bond or a group represented by formula (6);
the formula (2) is: 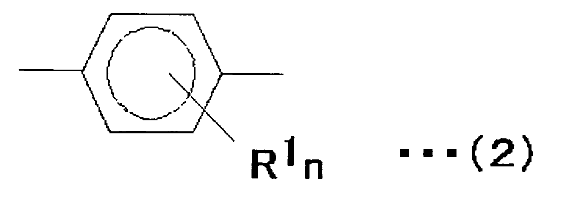 wherein R¹ is a hydrogen atom, an alkyl group having 1 to 10 carbon atoms, an alkoxyl group having 1-5 carbon atoms, or an aryl group having 6-14 carbon atoms; and n denotes an integer from 1 to 4;
the formula (3) is: 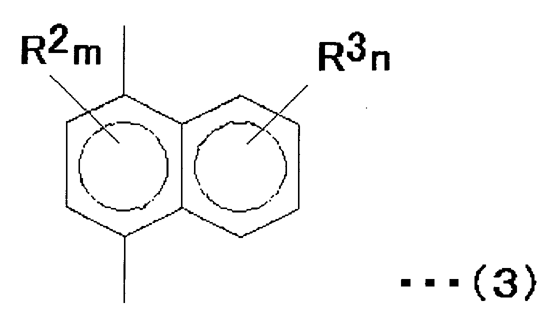 wherein each of R² and R³ denotes a hydrogen atom, an alkyl group having 1 to 10 carbon atoms, an alkoxyl group having 1-5 carbon atoms, or an aryl group having 6-14 carbon atoms, wherein R² and R³ may be the same or different from each other; m denotes an integer of 1 or 2; and n means the same as the above;
the formula (4) is: 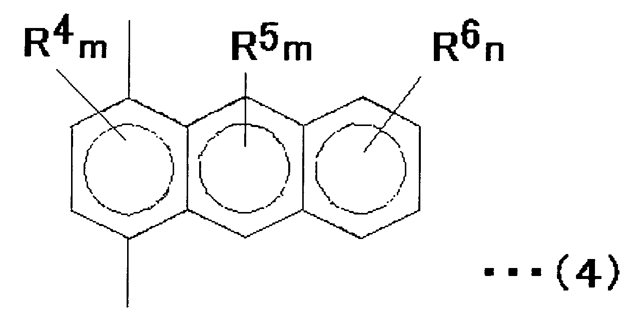 wherein each of R⁴, R⁵ and R⁶ denotes a hydrogen atom, an alkyl group having 1 to 10 carbon atoms, an alkoxyl group having 1-5 carbon atoms, or an aryl group having 6-14 carbon atoms, wherein R⁴, R⁵ and R⁶ may be the same or different from one another; m and n respectively mean the same as the above;
the formula (5) is: 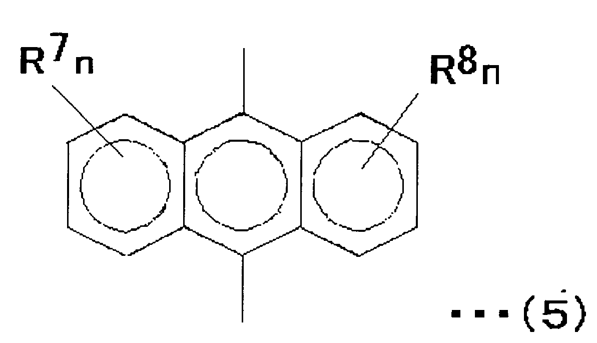 wherein each of R⁷ and R⁸ denotes a hydrogen atom, an alkyl group having 1 to 10 carbon atoms, an alkoxyl group having 1-5 carbon atoms, or an aryl group having 6-14 carbon atoms, wherein R⁷ and R⁸ may be the same or different from each other; and n means the same as the above; and
the formula (6) is: 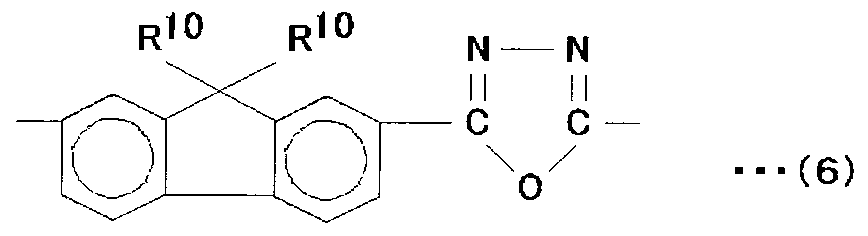 wherein R¹⁰ denotes a hydrogen atom or an alkyl group having 1-10 carbon atoms, and two R¹⁰s may be the same or different from each other.

2. A process of producing a blue light-emitting polymer having a repeating unit represented by the formula (1) shown in claim 1, comprising dehydrohalogenating an aromatic compound represented by formula (7) and an aromatic compound with a halogen atom represented by formula (8) to obtain a compound; acetylating the obtained compound; oxidizing the acetylated compound; hydrolyzing the oxidized compound to produce a dicarboxylic acid represented by formula (9); and condensation-polymerizing the dicarboxylic acid (9) and a hydrazinium salt, wherein
the formula (7) is:
**H-Ar**^{**1**}**-H** **(7)**
wherein Ar¹ denotes the same as that defined in claim 1; the formula (8) is:
**H-Ar**^{**2**}**-CH**_{**2**}**X** **(8)**
wherein Ar² denotes the same as that defined in claim 1, and X denotes a halogen atom; and
the formula (9) is:
**HOOC-Ar**^{**1**}**-CH**_{**2**}**-Ar**^{**2**}**-COOH** **(9)**

3. A process of producing a blue light-emitting polymer having a repeating unit represented by the formula (1) shown in claim 1, comprising acetylating a fluorene represented by formula (10); oxidizing the acetylated fluorene; hydrolyzing the oxidized acetylated fluorene to obtain a compound represented by formula (11); and condensation-polymerizing the compound (11) and the compound represented by the formula (9) shown in claim 2 in the presence of a hydrazinium salt, wherein
the formula (10) is: 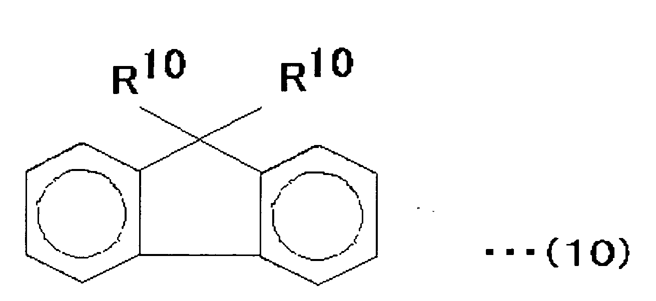 wherein R¹⁰ denotes a hydrogen atom or an alkyl group with 1-10 carbon atoms; and two R¹⁰s may be the same or different from each other; and
the formula (11) is:

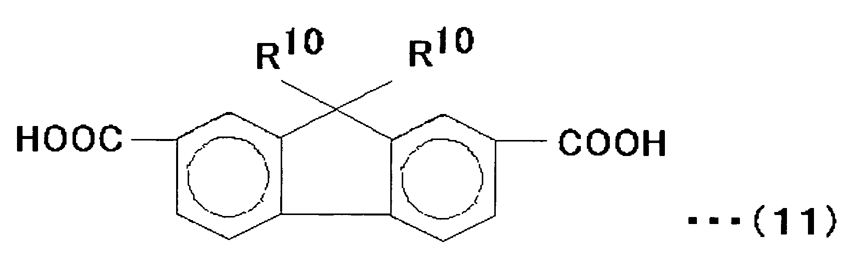

4. A luminescent element which has a light-emitting layer including a blue light-emitting polymer having a repeating unit represented by the formula (1) shown in claim 1 between a pair of electrodes.
